Europäisches Patentamt

European Patent Office

Office européen des brevets

(11) Veröffentlichungsnummer: **0 234 553**
A2

# (12) EUROPÄISCHE PATENTANMELDUNG

(21) Anmeldenummer: 87102586.2

(22) Anmeldetag: 24.02.87

(51) Int. Cl.⁴: **H05K 3/00** , G03F 7/02 , G03F 7/16

(30) Priorität: 26.02.86 DE 3606225

(43) Veröffentlichungstag der Anmeldung:
02.09.87 Patentblatt 87/36

(84) Benannte Vertragsstaaten:
AT BE CH DE FR GB IT LI NL

(71) Anmelder: **Siemens Aktiengesellschaft Berlin
und München
Wittelsbacherplatz 2
D-8000 München 2(DE)**

(72) Erfinder: **Merkenschlager, Hans-Hermann,
Dipl.-Ing.
Spielfeldstrasse 15
D-8900 Augsburg 21(DE)**

(54) **Verfahren zum Auflaminieren von Fotofolien auf Leiterplatten.**

(57) Die Erfindung bezieht sich auf zum Auflaminieren von Fotofolien auf kupferkaschierte Halbzeuge oder bereits strukturierte Leiterplatten, dabei lassen sich nicht ganz ebene Plattenoberflächen nicht mehr sicher homogen mit Folie beschichten, wodurch Fehler am Leiterbild auftreten. Das Verfahren nach der Erfindung vermeidet diesen Nachteil dadurch, daß vor der Laminierung der Fotofolie auf die Leiterplatte deren Oberfläche mittels einem dünnen Film aus Fotolack vorbeschichtet wird.

# FIG 2

EP 0 234 553 A2

## Verfahren zum Auflaminieren von Fotofolien auf Leiterplatten

Die Erfindung bezieht sich auf ein Verfahren zum Auflaminieren von Fotofolien auf kupferkaschierte Halbzeuge oder bereits strukturierte Leiterplatten.

Zur Bildübertragung vom Druckwerkzeug auf die Schaltungsplatte findet in der Leiterplattenfertigung in großem Umfang lichtempfindliche Fotofolie Anwendung. Diese Folie, unter Druck und Wärme auf die Plattenoberfläche aufgebracht, dient je nach Verfahrensvariante als Ätz-oder Galvanisierabdeckung; sie wird anschließend wieder von der Platte entfernt.

Nicht ganz ebene Plattenoberflächen - (Druckstellen, Welligkeit) lassen sich nicht mehr sicher homogen mit Folie beschichten, die Folienhaftung reicht oftmals nicht bis auf den Grund der Plattenoberfläche. Ergebnis sind Fehlstellen bei der Leiterbilderzeugung in Form von Leiterbahneinschnürungen, -Unterbrechungen oder -Verbreiterungen.

Verwendung eines verstärkten Laminierdruckes beim Aufrollen der Fotofolien, Erhöhung der Foliendicke oder erhöhte Aufwendungen für Planschleifen der Plattenoberfläche erbringen nur Teilerfolge. Es verbleibt bei hochwertigen Leiterplatten mit feinen Leiterbildkonfigurationen oftmals ein erheblicher Nacharbeitsaufwand bzw. Ausschuß.

Aufgabe der vorliegenden Erfindung ist es, ein Verfahren anzugeben, durch das der negative Einfluß der Oberflächenwelligkeit der Leiterplatten in einfacher Weise eliminiert wird.

Zur Lösung dieser Aufgabe wird gemäß der Erfindung derart verfahren, daß vor der Laminierung der Fotofolie auf die Leiterplatte deren Oberfläche mittels einem dünnen Film aus Fotolack vorbeschichtet wird.

Vorteilhaft ist es dabei, als Fotolack die gleiche Substanz aber in gelöster Form wie die der Fotofolie zu verwenden.

Durch die nun homogene Benetzung der Plattenoberfläche mit Fotoabdecklack lassen sich auch sehr feine Leiterstrukturen mit verbesserter Ausbeute erzeugen. Insbesondere ist diese Methode beim Tenting-Verfahren mit großen Nutzen anwendbar.

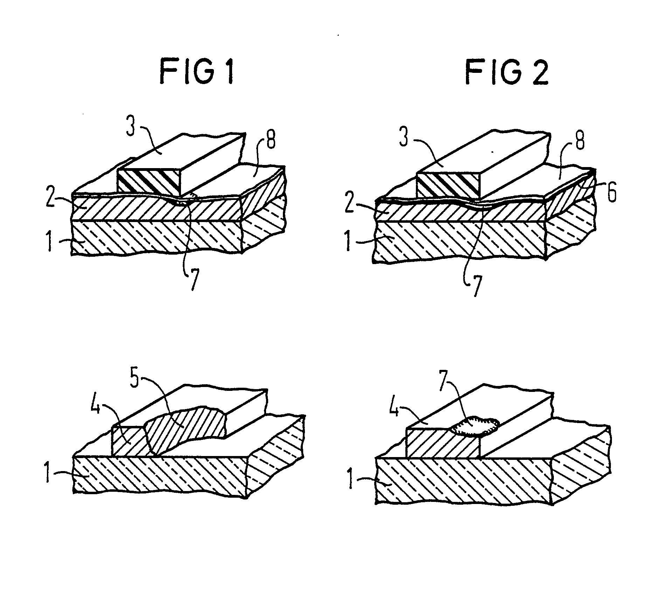

Anhand der Skizzen nach den FIG 1 und FIG 2 wird die Erfindung näher erläutert.

Es zeigen FIG 1 die Herstellung einer Leiterbahn ohne Aufbringung eines Fotolacks. FIG 2 die Herstellung einer Leiterbahn bei Aufbringen eines Fotolacks.

In den beiden Skizzen ist jeweils die Situation vor dem Belichten einer Leiterplatte und nach dem Ätzen untereinander dargestellt. Es ist jeweils ein Ausschnitt aus einer Leiterplatte gezeigt, mit dem Halbzeug 1, der aufkaschierten Kupferschicht 2 und der auf dieser Kupferschicht 2 liegenden Ätzmaske 3. Auf der Kupferschicht 2 ist eine Unebenheit 7 der Oberfläche der Kupferschicht 2 zu erkennen. Eine auf dieser Kupferschicht aufbringbare Fotofolie 8 ist aufgrund der Welligkeit 7 nur ungenügend mit dem gewellten Teil der Oberfläche der Kupferschicht 2 verbunden. Nach dem Belichten und Abnehmen der Ätzmaske werden zunächst die nichtbelichteten Teile der Ätzfolie entfernt und bei Ätzvorgang das nunmehr freiliegende Kupfer weggeätzt. Da an der Stelle 7 die Fotofolie nicht vollständig auflag, bildet sich dort nach dem Entwickeln eine Öffnung in die das Ätzmittel eindringt und auch Kupfer in jenem Bereich wegätzt in dem an sich durch die Abdeckung der Maske eine Belichtung stattgefunden hat, wodurch eine ätzresistente Schicht der Fotofolie entstanden ist. Die darunterliegende Zeichnung zeigt, daß an der Stelle 5 die Leiterbahn 4 durch Wegätzen des Kupfers erheblich verengt ist.

FIG 2 stellt den gleichen Vorgang bei Aufbringen einer zusätzlichen Fotolackschicht dar. Auch hier liegt die Fotofolie im Bereich 7, verursacht durch die Welligkeit der Oberfläche des Kupferbelages 2, nicht vollständig auf. Wird nunmehr die Fotofolie entwickelt, so bildet sich auch dort eine Öffnung in die Ätze eindringen kann. Da jedoch sich die Fotolackschicht 6 an die Unebenheiten der Oberfläche voll angeschmiegt hat, bleibt der belichtete Teil auf dem Kupfer 2 haften, so daß dieses von der Ätze nicht angegriffen werden kann. Im unteren Bild ist die geätzte Leiterplatte gezeigt, wobei die Leiterbahn vollständig erhalten ist, lediglich die ursprünglich vorhandene Welligkeit auf der Oberfläche ist an der Stelle 7 nach wie vor vorhanden.

Bezugszeichenliste

1 Halbzeug
2 Kupferschicht
3 Ätzmaske
4 Leiterbahn
5 Stelle
6 Fotolackschicht
7 Unebenheit
8 Fotofolie

**Ansprüche**

1. Verfahren zum Auflaminieren von Fotofolien auf kupferkaschierte Halbzeuge oder bereits strukturierte Leiterplatten,
**dadurch gekennzeichnet,** daß vor der Laminierung der Fotofolie auf die Leiterplatte deren Oberfläche mittels einem dünnen Film aus Fotolack vorbeschichtet wird.

2. Verfahren nach Anspruch 1,
**dadurch gekennzeichnet,** daß als Fotolack die gleiche Substanz aber in gelöster Form wie die der Fotofolie verwendet wird.

# FIG 1

# FIG 2